(19)

**Europäisches Patentamt**
**European Patent Office**
**Office européen des brevets**

(11) **EP 4 752 778 A1**

(12) **EUROPEAN PATENT APPLICATION**
published in accordance with Art. 153(4) EPC

(43) Date of publication:
**03.06.2026 Bulletin 2026/23**

(51) International Patent Classification (IPC):
**G06F 30/10** (2020.01)

(21) Application number: **24844776.5**

(22) Date of filing: **23.07.2024**

(86) International application number:
**PCT/CN2024/106921**

(87) International publication number:
**WO 2025/021085 (30.01.2025 Gazette 2025/05)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.07.2023 CN 202310911850**

(71) Applicant: **Academy of Mathematics and System Sciences,**
**Chinese Academy of Sciences**
**100190 Beijing (CN)**

(72) Inventors:
• **JIA, Xiaohong**
  **Beijing 100190 (CN)**
• **YANG, Jieyin**
  **Beijing 100190 (CN)**

(74) Representative: **De Vries & Metman**
**Overschiestraat 180**
**1062 XK Amsterdam (NL)**

(54) **CAD MODEL CONSTRUCTION METHOD BASED ON FAST NURBS SURFACE INTERSECTION ALGORITHM**

(57) Provided in the present disclosure is a CAD model construction method based on a fast NURBS surface intersection algorithm, which is applied to the technical field of CAD/CAM and geometric modeling. The method comprises: constructing an original CAD model comprising a group of NURBS surfaces, and carrying out collision detection on oriented bounding boxes formed by control points of every two NURBS surfaces; if the bounding boxes intersect, dividing the NURBS surfaces into a plurality of Bezier surfaces; carrying out collision detection on oriented bounding boxes formed by control points of the Bezier surfaces; for a surface pair $(P_1, Q_1)$ of which the collision of bounding boxes is detected, selecting the surface $P_1$ of a lower degree for fast parameter surface implicitization; and, according to obtained intersection lines, trimming the NURBS surfaces, so as to construct a final CAD model. The present disclosure solves the difficulty in CAD in solving intersection lines when two surfaces are located at special positions, and rapidly obtains the intersection lines, thus allowing for more robust surface model construction in CAD.

| | |
|---|---|
| Perform collision detection on direction bounding boxes formed by control points of NURBS surfaces P and Q | S1 |
| Divide the NURBS surfaces into multiple Bezier surfaces | S2 |
| Perform the collision detection on the direction bounding boxes formed by control points of the Bezier surfaces | S3 |
| For a surfaces pair $(P_1, Q_1)$ that detected collisions, select a surface $P_1$ with a lower degree, and perform fast implicitization on the surface | S4 |
| Substitute a parameter representation of $Q_1$ into the implicit equation of $P_1$ to obtain two-dimensional intersection line implicit expressed, and calculate characteristic points of the two-dimensional intersection line using a resultant | S5 |
| Use the characteristic points as starting points to perform a trace on two-dimensional implicit curves | S6 |
| Lift two-dimensional intersection line obtained by tracing to three-dimensional space to obtain three-dimensional intersection line | S7 |
| Calculate intersection points of boundary lines of $P_1$ and the three-dimensional intersection line, and split the three-dimensional intersection line into multiple segments at the intersection points | S8 |
| Calculate a parameter value on $P_1$ corresponding to any point on the segments | S9 |
| Determine whether the segments are to be trimmed based on whether the parameter value falls within a parameter domain, and obtain a final intersection line | S10 |
| Trim the NURBS surfaces based on an intersection line to construct a CAD model | S11 |

FIG. 1

**Description**

**CROSS REFERENCE TO RELATED APPLICATION**

The present application claims the priority of the Chinese Patent Application No. 2023109118506, titled "CAD MODEL CONSTRUCTION METHOD BASED ON FAST NURBS SURFACE INTERSECTION ALGORITHM", filed on July 24, 2023, which is incorporated herein by reference in its entirety.

**TECHNICAL FIELD**

The present disclosure relates to the field of CAD/CAM and geometric modeling technology, and in particular to a CAD model construction method based on a fast intersection algorithm for NURBS surfaces.

**BACKGROUND**

NURBS surface intersection is a fundamental task in Computer Aided Design (CAD) and geometric modeling systems. In many CAD system modeling operations such as Boolean operations, mesh generation, and rendering, efficient, robust, and topologically correct NURBS surface intersection algorithms are required. Currently, the main reason for the low reliability of CAD systems in the industry is the lack of efficient and topologically correct NURBS surface intersection algorithms.

The methods for NURBS surface intersection mainly fall into two categories: algebraic methods and discrete methods. The surface intersection method disclosed herein belongs to the algebraic method, which can guarantee the topological correctness of the intersection curve compared to the discrete method, and do not lose isolated points and small loops in the intersection line. Accordingly, compared with traditional algebraic methods, the computational efficiency can be improved in the present application.

**SUMMARY**

In view of this, the present disclosure provides a CAD model construction method based on a fast intersection algorithm for NURBS surfaces, which ensures the topological correctness of the intersection lines of two NURBS surfaces in CAD and can quickly calculate the intersection lines, making the construction of surface models in CAD more robust.

To achieve the above purpose, the present disclosure provides the following technical solutions.

A CAD model construction method based on a fast intersection algorithm for NURBS surfaces is provided, including the following steps:

S1, constructing an original CAD model including a group of NURBS surfaces, and performing collision detection on direction bounding boxes formed by control points of each pair of NURBS surfaces;

S2, dividing the NURBS surfaces into multiple Bezier surfaces when the bounding boxes intersect;

S3, performing the collision detection on the direction bounding boxes formed by control points of the Bezier surfaces;

S4, for a Bezier surfaces pair $(P_1, Q_1)$ that detected bounding boxes collisions, selecting a parameter surface $P_1$ with a lower degree, and performing fast implicitization on the parameter surface;

S5, substituting a parameter representation of $Q_1$ into the implicit equation of $P_1$ to obtain two-dimensional intersection line implicit expressed, and calculating characteristic points of the two-dimensional intersection line using a resultant;

S6, using the characteristic points as starting points to perform a trace on two-dimensional implicit curves;

S7, lifting two-dimensional intersection line obtained by tracing to three-dimensional space to obtain three-dimensional intersection line;

S8, calculating intersection points of boundary lines of $P_1$ and the three-dimensional intersection line, and splitting the three-dimensional intersection line into multiple branches at the intersection points;

S9, calculating a parameter value on $P_1$ corresponding to any point on the branches;

S10, determining whether the branches are to be trimmed based on whether the parameter value falls within a parameter domain, and obtaining a final intersection line; and

S11, trimming the NURBS surfaces based on an obtained intersection line to construct a final CAD model.

Optionally, in S2, the NURBS surfaces are divided into multiple Bezier surfaces by a method of inserting knots.

Optionally, in S3, the collision detection is performed on the direction bounding boxes formed by the control points of the Bezier surface to quickly eliminate non-intersecting regions and retain intersecting Bezier surfaces pair $(P_1, Q_1)$, and convert the intersecting Bezier surfaces pair $(P_1, Q_1)$ into parametric surface representations.

Optionally, in S4, an implicitization of a parametric surface $P_1$ is rapidly calculated through a moving plane associated with the parametric surface $P_1$.

Optionally, in S6, the two-dimensional implicit curves are traced by using the characteristic points as the starting points, and two-dimensional intersection line point sequence is iteratively calculated by Newton method with a given step size, and a next characteristic point or boundary of the parameter domain as a termination condition.

Optionally, in S7, the two-dimensional intersection line point sequence obtained by tracing is substituted into parametric surface $Q_1$ to obtain three-dimensional intersection line point sequence.

Optionally, in S8, the boundary lines of $P_1$ are discretely sampled, and points in the three-dimensional intersection line point sequence within a distance from the point sequence of the boundary lines of $P_1$ that are less than a given error are found and marked as intersection points of the boundary lines and the three-dimensional intersection line, the intersection line is split into multiple branches at the intersection points.

Optionally, in S9, the parameter value on $P_1$ corresponding to any point on the branches are obtained by calculating a null space of a Dixon matrix corresponding to any point on the branches.

Optionally, in S10, the branches that is to be trimmed are determined based on whether the parameter value of any point in each branch falls within a parameter domain of $P_1$, branches within the parameter domain are retained, and branches outside the parameter domain are discarded.

## BRIEF DESCRIPTION OF THE DRAWINGS

To more clearly illustrate the technical solutions in these embodiments of the present disclosure or related technologies, the following will briefly introduce the attached drawings in the description of these embodiments or related technologies. The attached drawings described below are only the embodiments of the present disclosure. For those skilled in the art, other drawings can be obtained without creative labor based on the provided attached drawings.

FIG. 1 is a flowchart of a CAD model construction method based on a fast intersection algorithm for NURBS surfaces provided by the present disclosure.

FIG. 2 is a detailed flowchart of the fast implicitization process based on the moving plane theory in step S4 of the present disclosure.

FIG. 3 is a result schematic diagram of the characteristic points calculation process in step S5 of the present disclosure.

FIG. 4 is a result schematic diagram of the intersection line lifting process in step S7 of the present disclosure.

FIG. 5 is a result schematic diagram of the three-dimensional intersection line trimming process in steps S8-S10 of the present disclosure.

FIG. 6 is a calculation schematic diagram of determining whether to retain the intersection line branches in step S10 of the present disclosure.

FIG. 7 is a comparison result diagram of the intersection line topology and intersection time for calculating NURBS surfaces intersection line between the present disclosure and other existing methods.

FIG. 8 is a comparison result diagram of the time cost of calculating the intersection line between an ellipsoid and a torus surface by the method of the present disclosure and the intersection method of industrial software ACIS.

FIG. 9 is a result schematic diagram of calculating the intersection line of NURBS surfaces with different intersection line topologies by the present disclosure.

## DETAILED DESCRIPTION

The following will describe the technical solution of the present disclosure in detail with reference to the accompanying drawings. It should be noted that the described embodiments are merely a part of the embodiments of the present disclosure, not all of them. All other embodiments obtained by ordinary technicians in the field without making creative efforts based on the embodiments of the present disclosure are within the scope of protection of the present disclosure.

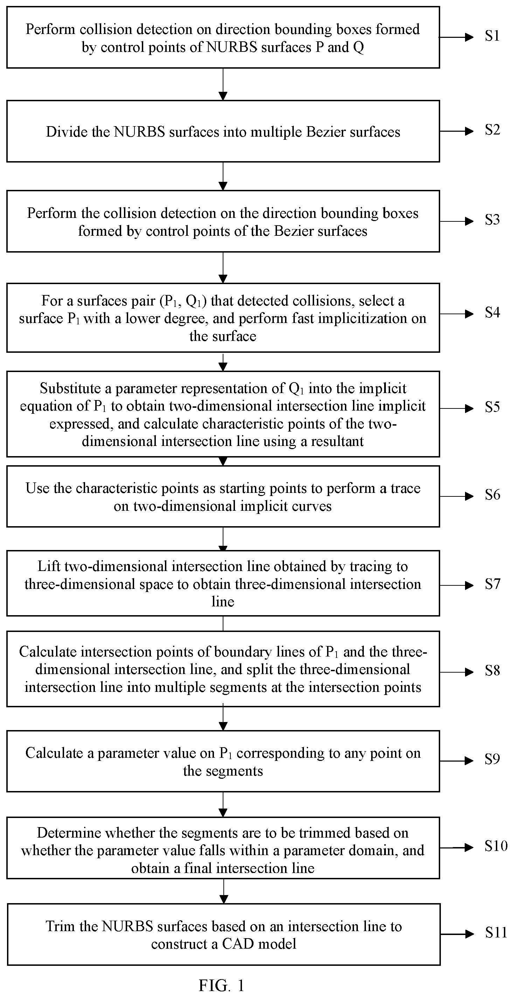

Referring to FIG. 1, the present disclosure provides a CAD model construction method based on a fast intersection algorithm for NURBS surfaces, including following steps:

S1, constructing an original CAD model including a group of NURBS surfaces, and performing collision detection on direction bounding boxes formed by control points of each pair of NURBS surfaces, and determining whether the direction bounding boxes of these two NURBS surfaces intersect;

S2, dividing the NURBS surfaces into multiple Bezier surfaces when the bounding boxes intersect;

S3, performing the collision detection on the direction bounding boxes formed by control points of the Bezier surfaces;

S4, for a Bezier surfaces pair $(P_1, Q_1)$ that detected bounding boxes collisions, selecting a parameter surface $P_1$ with a lower degree, and performing fast implicitization on the parameter surface;

S5, substituting a parameter representation of $Q_1$ into the implicit equation of $P_1$ to obtain two-dimensional intersection line implicit expressed, and calculating characteristic points of the two-dimensional intersection line using a resultant;

S6, using the characteristic points as starting points to perform a trace on two-dimensional implicit curves;

S7, lifting two-dimensional intersection line obtained by tracing to three-dimensional space to obtain three-dimensional intersection line;

S8, calculating intersection points of boundary lines of $P_1$ and the three-dimensional intersection line, and splitting the three-dimensional intersection line into multiple branches at the intersection points;

S9, calculating a parameter value on $P_1$ corresponding to any point on the branches;

S10, determining whether the branches are to be trimmed based on whether the parameter value falls within a parameter domain, and obtaining a final intersection line; and

S11, trimming the NURBS surfaces based on an obtained intersection line to construct a final CAD model.

Specifically, in step S1, collision detection is performed on the direction bounding boxes formed by the control points of the NURBS surfaces P and Q.

The input of the present disclosure is two NURBS surfaces P and Q with degrees $(k_1, l_1)$ and $(k_2, l_2)$, respectively, where $k_1$, $l_1$, $k_2$, and $l_2$ are all positive integers representing the degrees of the NURBS surfaces P and Q. The control points $\overline{P}$, $\overline{Q}$, weights $W_1$, $W_2$, and knot vectors $U_1$, $V_1$, $U_2$, $V_2$ are respectively:

$$\overline{P} = \{p_{i,j} \in \mathbb{R}^3 | i = 1,2,\cdots,m_1 + 1, j = 1,2,\cdots,n_1 + 1\} \quad (1) ,$$

$$W_1 = \{w_{i,j} \in \mathbb{R} | i = 1,2,\cdots,m_1 + 1, j = 1,2,\cdots,n_1 + 1\} \quad (2) ,$$

$$U_1 = \{u_{1,0}, u_{1,1}, \cdots, u_{1,m_1+k_1}\}, V_1 = \{v_{1,0}, v_{1,1}, \cdots, v_{1,n_1+l_1}\} \quad (3) ,$$

$$\overline{Q} = \{q_{i,j} \in \mathbb{R}^3 | i = 1,2,\cdots,m_2 + 1, j = 1,2,\cdots,n_2 + 1\} \quad (4) ,$$

$$W_2 = \{w'_{i,j} \in \mathbb{R} | i = 1,2,\cdots,m_2 + 1, j = 1,2,\cdots,n_2 + 1\} \quad (5) ,$$

$$U_2 = \{u_{2,0}, u_{2,1}, \cdots, u_{2,m_2+k_2}\}, V_2 = \{v_{2,0}, v_{2,1}, \cdots, v_{2,n_2+l_2}\} \quad (6) .$$

The control points $\overline{P}$, $\overline{Q}$, weights $W_1$, $W_2$ and knot vectors $U_1$, $V_1$, $U_2$, $V_2$ jointly define the NURBS surfaces P and Q, which are the parametric representations of NURBS surfaces P and Q. The $\{p_{i,j}\}$ represents the control points of NURBS surface P. The $m_1$ is used to record the number of control points $\overline{P}$ in one parameter direction, and its value range is non-negative integers. The $n_1$ is used to record the number of control points $\overline{P}$ in another parameter direction, and its value range is non-negative integers. The $\{w_{i,j}\}$ is the weight corresponding to the control points $\{p_{i,j}\}$. The $\{u_{1,0}, u_{1,1}, \cdots, u_{1,m1+k1}\}$ is the knot vector of surface P in the first parameter direction, where each $u_{1,i}$, $i \in \{0,1, \cdots, m_1 + k_1\}$ is a real number and satisfies $u_{1,i} \le u_{1,i+1}$. The $\{v_{1,0}, v_{1,1}, \cdots, v_{1,n1+l1}\}$ is the knot vector of surface P in the second parameter direction, where each $v_{1,i}$, $i \in \{0, \cdots, n_1 + l_1\}$ is a real number and satisfies $v_{1,i} \le v_{1,i+1}$. The $\{q_{i,j}\}$ represents the control points of NURBS surface Q. The $m_2$ is used to record the number of control points $\overline{Q}$ in one parameter direction, and its value range is non-negative integers. The $n_2$ is used to record the number of control points $\overline{Q}$ in another parameter direction, and its value range is non-negative integers. The $\{w'_{i,j}\}$ is the weight corresponding to the control points $\{q_{i,j}\}$. The $\{u_{2,0}, u_{2,1} \cdots, u_{2,m2+k2}\}$ is the knot vector of surface Q in the first parameter direction, where each $u_{2,i}$, $i \in \{0,1,\cdots,m_2 + k_2\}$ is a real number and satisfies $u_{2,i} \le u_{2,i+1}$. The $\{v_{2,0}, v_{2,1}, \cdots, v_{2,n2+l2}\}$ is the knot vector of surface Q in the second parameter direction, where each $v_{2,i}$, $i \in \{0,1, \cdots, n_2 + l_2\}$ is a real number and satisfies $v_{2,i} \le v_{2,i+1}$. Based on the above parameters, calculate the direction bounding boxes Box1 and Box2 of the control points $\overline{P}$ and $\overline{Q}$ of surfaces P and Q respectively. If Box1 and Box2 do not intersect, it indicates that the two surfaces do not intersect, and return no intersection. If Box1 and Box2 intersect, it indicates that the two surfaces may intersect.

In step S2, if the direction bounding boxes Box1 and Box2 of the two surfaces in S1 intersect, then the surfaces P and Q are divided into several (multiple, i.e., two or more) Bezier surfaces by the method of inserting knots.

The conversion of NURBS surfaces to Bezier surfaces involves a process called knot insertion, the purpose is to make the knot vectors of NURBS surfaces uniform, so that each interval contains only one non-zero basis function, thereby making each interval correspond to a separate Bezier surface.

In step S3, the control points of the Bezier surfaces are calculated to determine whether the bounding boxes collide, thereby obtaining a series of colliding Bezier surface pairs: $(P_1, Q_1), (P_2, Q_2), \cdots, (P_r, Q_r)$, where, r is an integer greater than or equal to 1.

In step S4, for all the Bezier surface pairs: $(P_1, Q_1), (P_2, Q_2), ..., (P_r, Q_r)$ obtained from S3, operations similar to those for $(P_1, Q_1)$ are performed. The Bezier surfaces pair $P_1, Q_1$ are expressed in homogeneous parameter form as $P_1(u, v), Q_1(s, t)$:

$$P_1(u, v) = \big(a_1(u, v), b_1(u, v), c_1(u, v), d_1(u, v)\big) \ （7） ,$$

$$Q_1(s, t) = \big(a_2(s, t), b_2(s, t), c_2(s, t), d_2(s, t)\big) \ （8） .$$

Where, u and v are the two variables in the polynomial parameter representation corresponding to Bezier surface $P_1$, representing the parameter domain of Bezier surface $P_1$. The s and t are the two variables in the polynomial parameter representation corresponding to Bezier surface $Q_1$, representing the parameter domain of Bezier surface $Q_1$. The $a_1(u, v)$, $b_1(u, v)$, $c_1(u, v)$, $d_1(u, v)$ are all bivariate polynomials, among which $(a_1(u, v)/d_1(u, v), b_1(u, v)/d_1(u, v), c_1(u, v)/d_1(u, v))$ is the three-dimensional parameter representation of Bezier surface $P_1$. The degrees of $P_1(u, v)$ and $Q_q(s, t)$ are $(k_1, l_1)$ and $(k_2, l_2)$ respectively. The parameter surface with the lower implicit degree is took for fast implicitization, and is assumed to be $P_1(u, v)$. The implicit degree is the degree for polynomial implicitization. The parameter surface with the smaller sum of parameter degrees is chosen. For instance, it is assumed that $k_1 + l_1$ is less than $k_2 + l_2$. Specifically, it includes the following contents.

In step S41, the three moving planes corresponding to parameter surface $P_1$ are calculated:

$$f := d_1(u, v)x - a_1(u, v)w \ （9） ,$$

$$g := d_1(u, v)y - b_1(u, v)w \ （10） ,$$

$$h := d_1(u, v)z - c_1(u, v)w \ （11） .$$

Where f, g, and h represent three polynomials, which are also the moving planes about u and v. The x, y, z, and w are four newly introduced variables used to define the moving planes.

In step S42, the corresponding Dixon matrix is calculated based on these three moving planes.

Three polynomials f (u, v), g (u, v), and h (u, v) of degree $(k_1, l_1)$ are given, these three polynomials are the foregoing moving planes. The corresponding $2k_1l_1 \times 2k_1l_1$ Dixon matrix D(f, g, h) is defined as the result determined by

$$\frac{\begin{vmatrix} f(u,v) & g(u,v) & h(u,v) \\ f(u,\beta) & g(u,\beta) & h(u,\beta) \\ f(\alpha,\beta) & g(\alpha,\beta) & h(\alpha,\beta) \end{vmatrix}}{(u-\alpha)(v-\beta)} = (1, \alpha, \beta, ..., \alpha^{k_1-1}\beta^{2l_1-1})D(f, g, h)(1, u, v, ... u^{2k_1-1}v^{l_1-1})' .$$ The $\alpha$ and $\beta$ are intermediate unknown quantities introduced and are eliminated in the end.

In step S43, the maximum linearly independent submatrix of the Dixon matrix is found.

The implicit equation of the Bezier surface $P_1(u, v)$ is the greatest common divisor of the determinants of the maximum linearly independent submatrices of D (f, g, h). Since directly calculating the rank of D (f, g, h) is difficult, a practical strategy is provided here. A set of parameters $X_i = (x_i, y_i, z_i, w_i)$, $i = 1, 2, \cdots, k$ is randomly generated and substituted into the Dixon matrix, then $r_i = \text{rank}(D(X_i))$ is calculated. The values of most $r_i$ are the same as the rank of the Dixon matrix, and the linearly independent rows of the numerical matrices corresponding to these $r_i$ are the maximum linearly independent rows of the original Dixon matrix. Through this strategy, the calculation of the maximum linearly independent submatrix of the polynomial matrix, which is originally difficult, is transformed into the calculation of the linearly independent rows of the numerical matrix, thereby greatly improving the computational efficiency. The $x_i$, $y_i$, $z_i$, and $w_i$ are arbitrary real numbers as the assigned values of the variables x, y, z, and w. The k is the number of parameters $X_i$, taking positive integer values, and the value in the experiment is 10.

In step S44, the implicit equation of the parametric surface is obtained by calculating the determinant of the submatrix. From step S43, a series of maximum linearly independent submatrices are obtained. The greatest common divisor of the determinants of these submatrices is the implicit equation F (x, y, z, w) = 0 of the parametric surface $P_1(u, v)$.

In step S4, the process of constructing the Dixon matrix through three moving planes and performing implicitization has higher computational efficiency compared to the implicitization based on Grobner bases in related technologies.

In step S5, the parameter representation of $Q_1$, denoted as $Q_1$ (s, t), is substituted into the implicit equation F (x, y, z, w) = 0 of $P_1$:

$$g(s,t) := F\big(a_2(s,t), b_2(s,t), c_2(s,t), d_2(s,t)\big) \quad (12) \ .$$

The two-dimensional intersection line implicit expressed $C := \{(s, t) \in$

$\mathbb{R}^2 | g(s, t) = 0, (s, t) \in [s_0, s_1] \times [t_0, t_1]\}$ is obtained. $s_0$, $s_1$, $t_0$, and $t_1$ are all real numbers, representing the parameter range of the parameter surface $Q_1$. The intersection line $C$ is the projection of the intersection line of the parameter surface $Q_1$ and the implicit surface corresponding to the parameter surface $P_1$ in the parameter domain (s, t).

The resultant $R(s) := \text{Res}_t(g, \frac{\partial g}{\partial t})$ of g(s,t) and $\frac{\partial g}{\partial t}(s, t)$ with respect to t is calculated, and the real roots of R(s) = 0 within the parameter domain $s \in [s_0, s_1]$ is calculated, $\alpha_1, \alpha_2, ..., \alpha_n$ are obtained, and their corresponding real root isolation intervals $[l_1, r_1], [l_1, r_1], \cdots, [l_n, r_n]$ are obtained. Where, $l_i, r_i, i \in \{1, 2, \cdots, n\}$ are rational numbers, and n is a positive integer greater than or equal to 1. Then, each $l_i, r_i$ is substituted into g (s, t) to solve for the real roots of g($l_i$, t) = 0 and g($r_i$, t) = 0 within the parameter domain $t \in [t_0, t_1]$. Finally, several characteristic points are obtained. By calculating the characteristic points of the implicit curve through the resultant, the topological correctness of the intersection line is ensured. The implicit representation of the intersection line in the two-dimensional parameter domain is the implicit intersection line or implicit curve.

In step S6, the characteristic points calculated in S5 are used as the starting points to trace the two-dimensional implicit curve (two-dimensional implicit intersection line, that is, the two-dimensional intersection line implicit expressed). The tracing method is divided into two parts. Any characteristic point $p_1$ is took as an example:

(1) Initial estimation: $p_1 = (s, t)$, and the equation satisfied by the curve C is F (s, t) = 0. Here, F is the same as the F (x, y, z, w) mentioned above. Then, the initial estimation of the next tracing point by the tracing method is $(s + \Delta s^{(0)}, t + \Delta t^{(0)})$, satisfying:

$$\begin{pmatrix} \Delta s^{(0)} \\ \Delta t^{(0)} \end{pmatrix} = \text{sign} \cdot \frac{h}{\sqrt{F_s^2(s,t) + F_t^2(s,t)}} \begin{pmatrix} -F_t(s,t) \\ F_s(s,t) \end{pmatrix} \quad (13) \ ,$$

$$\text{sign} = \begin{cases} -1, & -F_t(s,t) < 0 \\ 1, & \text{otherwise} \end{cases} \quad (14) \ ,$$

where, $\Delta s^{(0)}$ is a small real number, representing the distance by which s increases, and in the experiment, it is taken as 0.001. $\Delta t^{(0)}$ is also a small real number, representing the distance by which t increases, and in the experiment, it is taken as 0.001. $F_t$ (s, t) is the partial derivative of the polynomial F with respect to t. $F_s$ (s, t) is the partial derivative of the polynomial F with respect to s. The h is the given marching step size or given size, which is a small positive real number, and in the experiment, it is given as 0.05;

(2) Newton iteration: assuming that $(\Delta s^{(j)}, \Delta t^{(j)})$ has already been obtained, then

$$\begin{pmatrix} \Delta s^{(j+1)} \\ \Delta t^{(j+1)} \end{pmatrix} = \begin{pmatrix} \cos \omega^{(j)} & \sin \omega^{(j)} \\ -\sin \omega^{(j)} & \cos \omega^{(j)} \end{pmatrix} \begin{pmatrix} \Delta s^{(j)} \\ \Delta t^{(j)} \end{pmatrix} \quad (15) \ ,$$

$$\omega^{(j)} := \frac{F}{\sqrt{-\Delta t^{(j)} F_s + \Delta s^{(j)} F_t}} \quad (16) \ .$$

In formulas (15) and (16), j is a local variable used for counting, taking positive integer values, and it has a different meaning from the j in the foregoing formulas (1) - (5). The iterative steps continue until the $l_2$ distance between $(\Delta s^{(j)}, \Delta t^{(j)})$ and $(\Delta s^{(j+1)}, \Delta t^{(j+1)})$ is less than the given value $\varepsilon$. The $l_2$ distance can be the Euclidean distance between two points, but is not limited to this in this disclosure. The given value $\varepsilon$ is a very small positive number, and in the experiment, it is set to 1e-6. At this point, the next step point of $p_1$ is taken as $P_{l+1} = (s + \Delta s^{(j)}, t + \Delta t^{(j)})$. The $P_{l+1}$ is used as the starting point, the above two steps are repeated to trace on the curve until the step point encounters the next characteristic point or the boundary of the parameter domain.

The parameter domain of a NURBS surface is usually a rectangular area, with its boundaries composed of four edges. These boundaries determine the range of values for the parameters u and v of the surface. For example, if the parameter domain of surface $P_1$ is $[u_0, u_1] \times [v_0, v_1]$, the four boundaries are:

$$\{(u, v) \in \mathbb{R}^2 | u = u_0, v \in [v_0, v_1]\}, \{(u, v) \in$$

$$\mathbb{R}^2 | u = u_1, v \in [v_0, v_1]\}, \{(u, v) \in \mathbb{R}^2 | u \in [u_0, u_1], v = v_0\}, \{(u, v) \in \mathbb{R}^2 | u \in [u_0, u_1], v = v_1\}.$$

In step S7, the two-dimensional intersection line point sequence obtained by tracing is lifted to three-dimensional space. For each two-dimensional point (s, t), its corresponding three-dimensional point is:

$$q := \left( \frac{a_2(s,t)}{d_2(s,t)}, \frac{b_2(s,t)}{d_2(s,t)}, \frac{c_2(s,t)}{d_2(s,t)} \right) \quad (17) \ .$$

Then the three-dimensional intersection line point sequence $\bar{\mathcal{C}}$ is obtained.

In step S8, u and v are firstly sampled on the four boundaries of $P_1$ with a step size of 1/N, where N is a positive integer, and in the experiment, the value is taken as 100. Then a series of boundary points $T = \{P_j = P_1(u_j, v_j)\}_{j=1}^{\alpha}$ are obtained. Here, $\alpha$ is a local counter indicating the number of boundary points obtained, which is not the same as the $\alpha$ in the foregoing Dixon matrix D (f, g, h). The intersection points of the three-dimensional intersection line $\bar{\mathcal{C}}$ and the boundaries are determined. Specifically, whether there are points in the three-dimensional intersection line point sequence that are close enough to the boundary points T is determined. If such an intersection point p exists, then the intersection line is disconnected at point p, and finally the intersection line branches $\bar{\mathcal{C}}_0, \bar{\mathcal{C}}_1, \cdots, \bar{\mathcal{C}}_\gamma$ are obtained.

In step S9, the parameter values on $P_1$ corresponding to any point on the branches are calculated. For each branch $\bar{\mathcal{C}}_i$, $i = 1, 2, \cdots, \gamma$, any point $q_i$ is took. If the parameter values (u, v) calculated through the Dixon matrix for $q_i$ are (u, v) $\in [u_0, u_1] \times [v_0, v_1]$, then this branch $\bar{\mathcal{C}}_i$ is retained; otherwise, if the parameter values (u, v) calculated through the Dixon matrix for $q_i$ are outside the parameter domain $[u_0, u_1] \times [v_0, v_1]$, then $\bar{\mathcal{C}}_i$ is discarded. The $\gamma$ is a positive integer representing the number of intersection line branches obtained. The $u_0$, $u_1$ and $v_0$, $v_1$ are all real numbers representing the value range of the parameter surface $P_1$. For any point X:= (x, y, z, 1) on $P_1$, it satisfies the implicit equation F (x, y, z, 1) = 0 corresponding to the parameter surface $P_1$, the parameter values can be represented by the null space of the numerical matrix of the Dixon matrix at that point. U(u, v) := [1, u, v, $\cdots$, $u^{m_1-1}v^{n_1-1}$]. Specifically, the parameter values (u*, v*) corresponding to point X satisfy D(X)U(u*, v*) = 0. The roots of D(X)U = 0 are solved with respect to (u, v). If solution (u, v) $\in [u_0, u_1] \times [v_0, v_1]$ exists, then point X is within the parameter range of the parameter surface $P_1$; if all real roots (u, v) are outside the parameter domain $[u_0, u_1] \times [v_0, v_1]$, it indicates that point X is not on the parameter surface $P_1$.

In step S 10, based on the parameter values of any point on each branch calculated in S9, the branches that are to be trimmed are determined by whether the parameter value falls within a parameter domain, and the final intersection line is obtained.

From the above technical solution, it can be seen that compared with related technologies, the present disclosure provides a CAD model construction method based on a fast intersection algorithm for NURBS surfaces, which has the following beneficial effects.

(1) The computational efficiency is improved. In this method, the bounding box collision detection of NURBS surfaces can quickly filter out regions without intersections, and the fast implicitization process of the surface in this method significantly reduces the computational time compared to traditional implicitization methods.

(2) The computational accuracy is enhanced. By using of symbolic computation, equations or expressions in analytical forms can be obtained, thereby reducing the rounding errors in the numerical computation process. This helps improve the accuracy and stability of the computation.

(3) The topological correctness of the intersection line is ensured. This method calculates characteristic points for each branch of the intersection line and performs curve tracking, and then trims the intersection line to ensure the topological correctness of the intersection line, thereby quickly obtaining the intersection line, making the construction of surface models in CAD more robust.

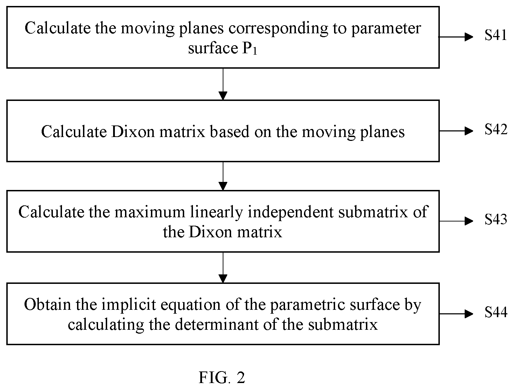

As shown in FIG. 2, step S4 is divided. In step S41, the three moving planes corresponding to parameter surface $P_1$ are calculated:

$$f := d_1(u,v)x - a_1(u,v)w,$$

$$g := d_1(u,v)y - b_1(u,v)w,$$

$$h := d_1(u,v)z - c_1(u,v)w.$$

In step S42, the corresponding Dixon matrix is calculated based on these three moving planes.

Three polynomials f (u, v), g (u, v), and h (u, v) of degree $(k_1, l_1)$ are given. The corresponding $2k_1 l_1 \times 2k_1 l_1$ Dixon matrix D(f, g, h) is defined as the result determined by

$$\frac{\begin{vmatrix} f(u,v) & g(u,v) & h(u,v) \\ f(u,\beta) & g(u,\beta) & h(u,\beta) \\ f(\alpha,\beta) & g(\alpha,\beta) & h(\alpha,\beta) \end{vmatrix}}{(u-\alpha)(v-\beta)} = (1, \alpha, \beta, ..., \alpha^{k_1-1}\beta^{2l_1-1})D(f,g,h)(1, u, v, ... u^{2k_1-1}v^{l_1-1})'.$$

In step S43, the maximum linearly independent submatrix of the Dixon matrix is calculated.

The implicit equation of the Bezier surface $P_1(u, v)$ is the greatest common divisor of the determinants of the maximum linearly independent submatrices of D (f, g, h). Since directly calculating the rank of D (f, g, h) is difficult, a practical strategy is provided here. A set of parameters $X_i = (x_i, y_i, z_i, w_i)$, i = 1,2, $\cdots$,k is randomly generated and substituted into the Dixon matrix, then $r_i = \text{rank}(D(X_i))$ is calculated. The values of most $r_i$ are the same as the rank of the Dixon matrix, and the linearly independent rows of the numerical matrices corresponding to these $r_i$ are the maximum linearly independent rows of the original Dixon matrix.

In step S44, the implicit equation of the parametric surface is obtained by calculating the determinant of the submatrix. From step S43, a series of maximum linearly independent submatrices are obtained. The greatest common divisor of the determinants of these submatrices is the implicit equation F (x, y, z, w) = 0 of the parametric surface $P_1$ (u, v).

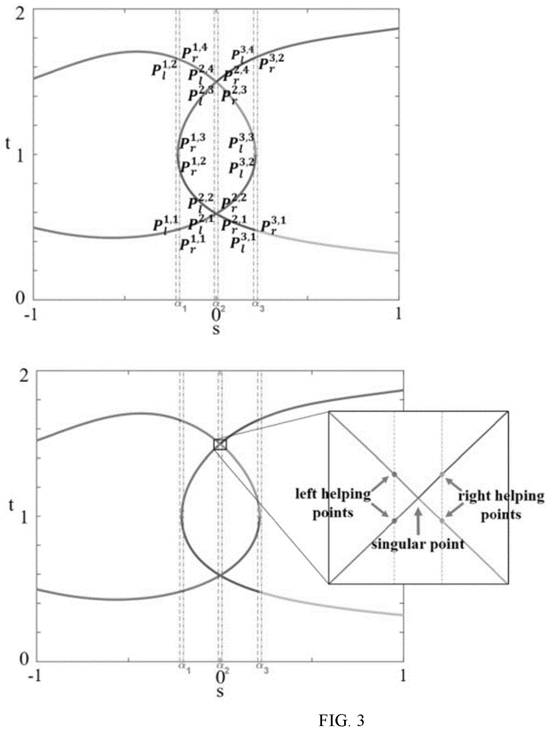

As shown in FIG. 3, it is an example of the process of calculating the characteristic points in step S5 of this disclosure. In FIG. 3, $P_l$ and $P_1$ are the left and right helping points corresponding to the characteristic points. The curves in the figure are the images of the curve g(s, t)=0 within the parameter domain [s, t] $\in$ [-1,1]×[0,2]. In the upper figure, $\alpha_1, \alpha_2$, and $\alpha_3$ are the s-coordinates of the critical points, and the vertical dashed lines give the isolation intervals of $\alpha_i$, i = 1,2,3. The curve g (s, t)=0 intersects the left values of all isolation intervals to form the left helping points, denoted by $P_l^{i,j}$; and intersects the right values of all isolation intervals to form the right helping points. The example in FIG. 3 has a singular point, and the helping points near it can also be successfully found.

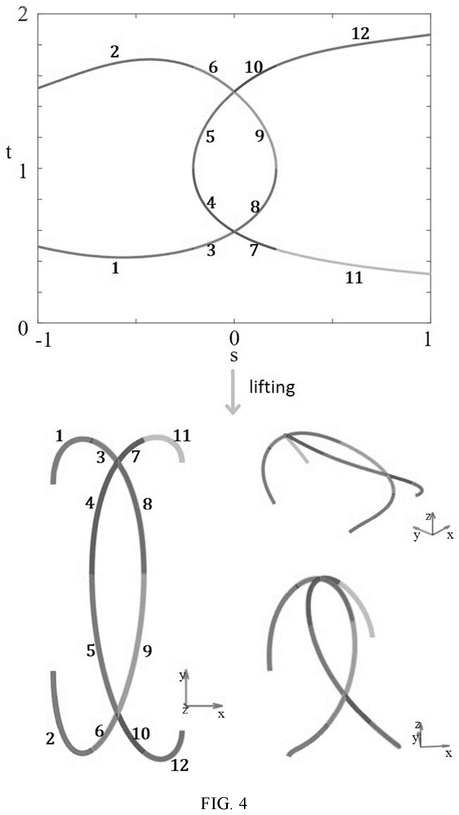

As shown in FIG. 4, it is the process of lifting the 2D intersection line to 3D in step S7 of this disclosure. The upper figure is a 2D intersection line, where different numbers represent different sub-branches. The lower figure is the 3D curve after lifting and its views from different perspectives. Each sub-branch of the 3D curve corresponds to a sub-branch of the 2D curve.

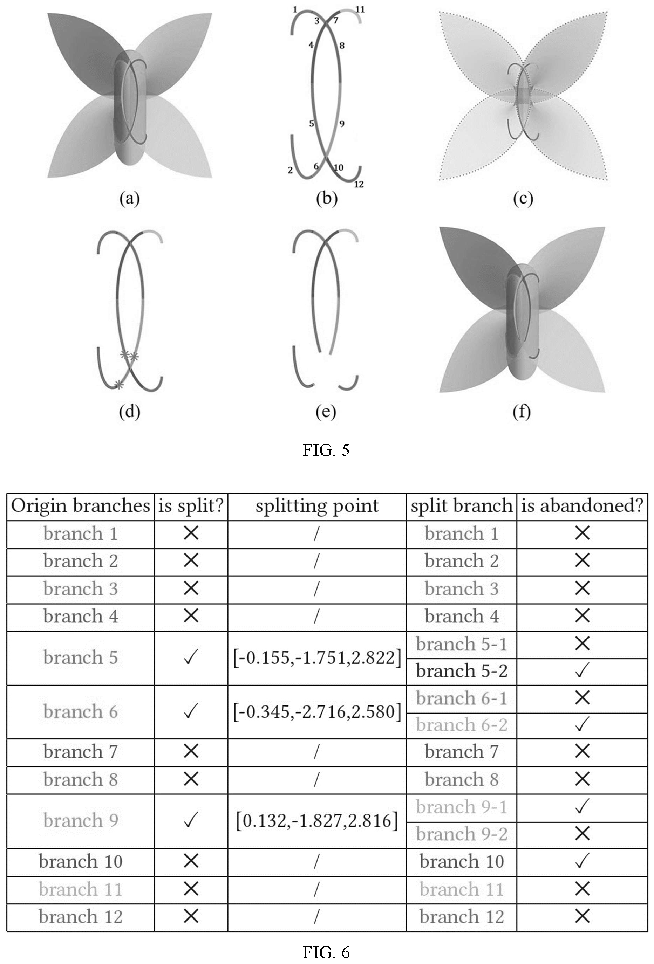

As shown in FIG. 5, it is the trimming process of three-dimensional intersection line in steps S8-S10 of this disclosure. Figure (a) shows a schematic diagram of the curve and surface before trimming. Different numbers in Figure (b) represent different sub-branches of the intersection line in the parameter domain (s, t). Figure (c) shows the discrete sampling of the boundary of surface $P_1$ in step S8, with the dotted points being the boundary points. Figure (d) shows the intersection points of the boundary calculated in step S8 and the curve, marked with asterisks. Figure (e) shows the sub-branches of the intersection line after screening in steps S9-S10. Figure (f) shows the surface and the final calculated intersection line.

As shown in FIG. 6, it is the analysis process of determining whether to retain the intersection line branches in step S10. The first column records different intersection line sub-branches before trimming. The second column records whether these branches intersect with the boundary. The third column records the intersection point values obtained for the branches that have intersection points with the boundary. The fourth column records the branches split at the intersection points. The fifth column calculates through step S9 whether each split branch is to be retained.

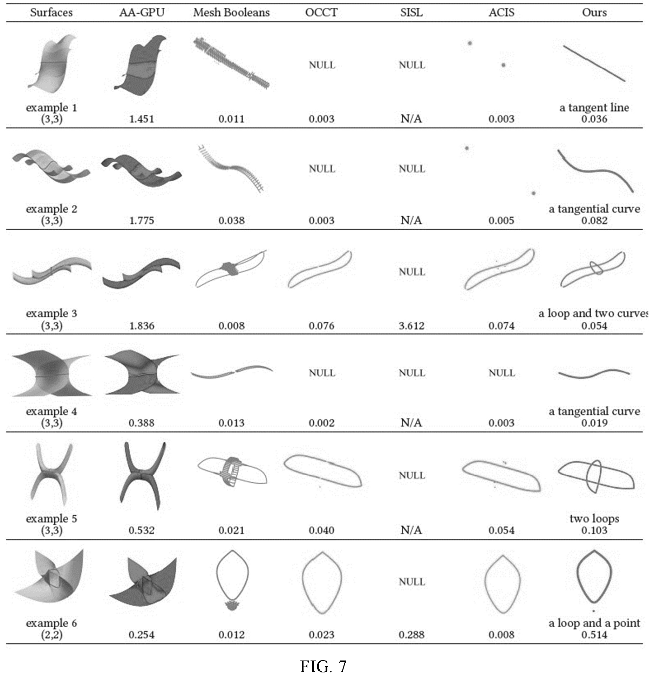

As shown in FIG. 7, it is a comparison result diagram of the intersection line topology and intersection time of NURBS surfaces intersection line among the method disclosed herein, the intersection algorithm based on affine arithmetic and GPU acceleration (AA-GPU), the intersection algorithm based on mesh (Mesh Booleans), the intersection algorithm in the open-source software OCCT and SISL, and the intersection algorithm in the commercial software ACIS. From the figure, it can be found that the algorithm provided by the embodiment of the present disclosure can ensure the intersection line topology when the surfaces are tangent or intersect at a single isolated point, while other methods lose some intersection lines to varying degrees or have problems with incorrect intersection line calculation. In terms of efficiency, the algorithm provided by the embodiment of the present disclosure is at the same order of magnitude as the other algorithms. The "NULL" indicates that the method does not return an intersection result in this example. "N/A" indicates that the method runs with an error in this example. The "a tangent line" indicates that the intersection line topology is a tangent straight line; "a tangential curve" indicates that the intersection line topology is a tangent curve; "a loop and two curves" indicates that the intersection line topology is a closed loop and two open intersection lines; "two loops" indicates that the intersection line topology is two closed loops; "a loop and a point" indicates that the intersection line topology is a closed loop and an isolated intersection point.

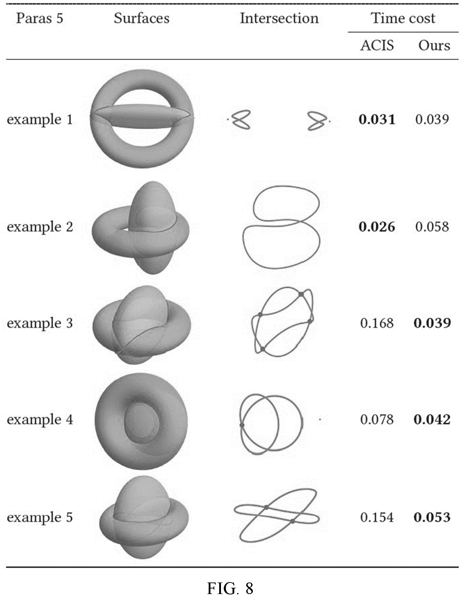

As shown in FIG. 8, it is a comparison result diagram of the time cost of our method and the intersection method of industrial software ACIS when calculating the intersection line of an ellipsoid and a torus. From the results, it can be concluded that both our method and the ACIS method can obtain the correct intersection line topology. In the case where there are crossing points (indicated by bold dots), our method is more efficient than the ACIS method.

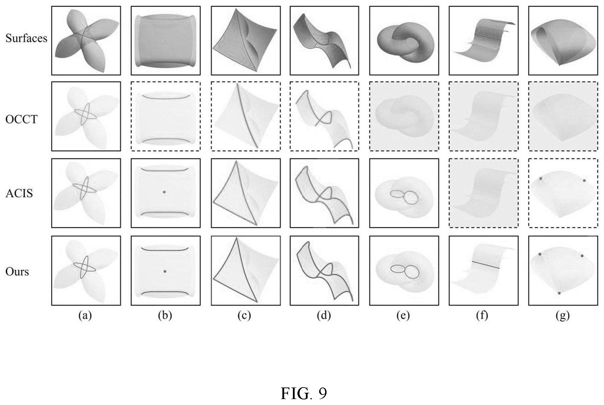

As shown in FIG. 9, it is a comparison result diagram of the intersection results of our algorithm and the open-source software OCC and the commercial software ACIS when calculating the intersection lines of NURBS surfaces with different intersection line topologies. From the figure, it can be concluded that our intersection algorithm is robust for various intersection line topologies, including (a) crossing points, (b) isolated tangent points, (c) (d) boundary intersection lines, (e) intersection lines of different branches, (f) high-order tangents, (g) multiple isolated intersection points. The intersection lines of our algorithm are shown in the last row, while the results of ACIS and OCCT are shown in the third and second rows respectively. The "NULL" indicates an empty curve result. Examples with dashed bounding boxes indicate incorrect topologies under this method. Our method provides the correct intersection line topology in all cases, while ACIS and OCCT sometimes make errors.

The technical solution of the present disclosure proposes a CAD model construction method based on a fast intersection algorithm for NURBS surfaces. In this method, symbolic computation is adopted for the fast implicitization and solution of characteristic points, and numerical computation is used for curve tracking and curve trimming, thereby effectively combining the accuracy of symbolic computation and the efficiency of numerical computation. In the process of implicitization of the moving plane, the idea of symbolic computation is utilized to obtain the implicitization of the parametric surface. In other words, the Dixon matrix is constructed through the moving plane, and the process of obtaining the implicitization of the surface utilizes the idea of symbolic computation. However, the parameters of the NURBS surfaces targeted by this method are all floating-point numbers, and numerical methods are used in the specific calculation process to make the algorithm more efficient. The topological structure of the intersection lines of NURBS surfaces is often complex and variable. It may contain cross points, isolated intersection points, boundary intersection lines, different intersection line branches, higher-order tangents, and singular points. When two NURBS surfaces are in special relative positions, such as being tangent or intersecting in small loops, existing methods often fail to correctly calculate all the intersection lines. For example, the subdivision method iteratively discretely subdivides the parameter domain of the surface when searching for intersection lines, which may lead to the omission of tangents or small loops. In contrast, our algorithm can find all the intersection line branches and ensure the correctness of the intersection line topology. In the process of screening the intersection area, our algorithm uses the collision detection of the NURBS control point direction bounding box, which can quickly eliminate the areas without intersection. In the algebraic method, the moving plane method is used to quickly implicate the surface, which improves the computational efficiency compared to the classical implicitization method. During the intersection line trimming process, the parameters of the intersection points are quickly solved using the Dixon matrix, and the unnecessary intersection line branches are quickly screened out.

The above experimental results and the method for calculating the intersection lines of two NURBS surfaces can be applied in various fields such as Boolean operations, mesh generation and rendering, hidden surface removal, and manufacturing, and have high practical application value.

The embodiments in this specification are described in a progressive manner. Each embodiment focuses on the differences from other embodiments, and the similar parts among the embodiments can be referred to each other. For the devices disclosed in the embodiments, since they correspond to the methods disclosed in the embodiments, they are described relatively simply. The relevant parts can be referred to the description of the methods.

The above description of the embodiments enables those skilled in the art to implement or use the present disclosure. Various modifications to these embodiments will be obvious to those skilled in the art, and the general principles defined herein can be applied to other embodiments without departing from the spirit or scope of the present disclosure. Therefore, the present disclosure is not limited to the embodiments shown herein, but is to be accorded the widest scope consistent with the principles and novel features disclosed herein.

**Claims**

1. A CAD model construction method based on a fast intersection algorithm for NURBS surfaces, comprising following steps:

   S1, constructing an original CAD model comprising a group of NURBS surfaces, and performing collision detection on direction bounding boxes formed by control points of each pair of NURB S surfaces;

   S2, dividing the NURBS surfaces into multiple Bezier surfaces when the bounding boxes intersect;

   S3, performing the collision detection on the direction bounding boxes formed by control points of the Bezier surfaces;

   S4, for a Bezier surfaces pair $(P_1, Q_1)$ that detected bounding boxes collisions, selecting a parameter surface with a lower degree from $P_1$ and $Q_1$, and performing fast implicitization on the parameter surface to obtain an implicit equation of $P_1$;

   S5, substituting a parameter representation of $Q_1$ into the implicit equation of $P_1$ to obtain two-dimensional intersection line implicit expressed, and calculating characteristic points of the two-dimensional intersection line using a resultant;

   S6, using the characteristic points as starting points to perform a trace on two-dimensional implicit curves;

   S7, lifting two-dimensional intersection line obtained by tracing to three-dimensional space to obtain three-dimensional intersection line;

   S8, calculating intersection points of boundary lines of $P_1$ and the three-dimensional intersection line, and splitting the three-dimensional intersection line into multiple branches at the intersection points;

   S9, calculating a parameter value on $P_1$ corresponding to any point on the branches;

   S10, determining whether the branches are to be trimmed based on whether the parameter value falls within a parameter domain, and obtaining a final intersection line; and

   S11, trimming the NURBS surfaces based on an obtained final intersection line to construct a final CAD model.

2. The CAD model construction method based on the fast intersection algorithm for NURBS surfaces according to claim 1, wherein
   in S2, the NURBS surfaces are divided into multiple Bezier surfaces by a method of inserting knots.

3. The CAD model construction method based on the fast intersection algorithm for NURBS surfaces according to claim 1, wherein
   in S3, the collision detection is performed on the direction bounding boxes formed by the control points of the Bezier surface to quickly eliminate non-intersecting regions and retain an intersecting Bezier surfaces pair $(P_1, Q_1)$, and convert the intersecting Bezier surfaces pair $(P_1, Q_1)$ into parametric surface representations.

4. The CAD model construction method based on the fast intersection algorithm for NURBS surfaces according to claim 1, wherein
   in S4, an implicitization of a parametric surface $P_1$ is rapidly calculated through a moving plane associated with the parametric surface $P_1$.

5. The CAD model construction method based on the fast intersection algorithm for NURBS surfaces according to claim 1, wherein
   in S6, the two-dimensional implicit curves are traced by using the characteristic points as the starting points, and two-dimensional intersection line point sequence is iteratively calculated by Newton method with a given step size, and a next characteristic point or boundary of the parameter domain as a termination condition.

6. The CAD model construction method based on the fast intersection algorithm for NURBS surfaces according to claim 5, wherein
   in S7, the two-dimensional intersection line point sequence obtained by tracing is substituted into parametric surface $Q_1$ to obtain three-dimensional intersection line point sequence.

7. The CAD model construction method based on the fast intersection algorithm for NURBS surfaces according to claim 6, wherein
   in S8, the boundary lines of $P_1$ are discretely sampled to obtain point sequence of the boundary lines of $P_1$, and points in the three-dimensional intersection line point sequence within a distance from the point sequence of the boundary lines of $P_1$ that are less than a given error are found and marked as intersection points of the boundary lines of $P_1$ and the three-dimensional intersection line, the intersection line is split into multiple branches at the intersection points.

8. The CAD model construction method based on the fast intersection algorithm for NURBS surfaces according to claim 1, wherein
in S9, the parameter value on $P_1$ corresponding to any point on the branches are obtained by calculating a null space of a Dixon matrix corresponding to any point on the branches.

9. The CAD model construction method based on the fast intersection algorithm for NURBS surfaces according to claim 1, wherein
in S10, the branches that is to be trimmed are determined based on whether the parameter value of any point in each branch falls within a parameter domain of $P_1$, branches within the parameter domain are retained, and branches outside the parameter domain are discarded.

10. The CAD model construction method based on the fast intersection algorithm for NURBS surfaces according to claim 1, wherein
step S7 specifically involves: lifting two-dimensional intersection line point sequence obtained by tracing to the three-dimensional space to obtain three-dimensional intersection line point sequence $\overline{\mathcal{C}}$; for each two-dimensional point (s, t), a corresponding three-dimensional point is:

$$q := \left( \frac{a_2(s,t)}{d_2(s,t)}, \frac{b_2(s,t)}{d_2(s,t)}, \frac{c_2(s,t)}{d_2(s,t)} \right).$$

Perform collision detection on direction bounding boxes formed by control points of NURBS surfaces P and Q → S1

Divide the NURBS surfaces into multiple Bezier surfaces → S2

Perform the collision detection on the direction bounding boxes formed by control points of the Bezier surfaces → S3

For a surfaces pair $(P_1, Q_1)$ that detected collisions, select a surface $P_1$ with a lower degree, and perform fast implicitization on the surface → S4

Substitute a parameter representation of $Q_1$ into the implicit equation of $P_1$ to obtain two-dimensional intersection line implicit expressed, and calculate characteristic points of the two-dimensional intersection line using a resultant → S5

Use the characteristic points as starting points to perform a trace on two-dimensional implicit curves → S6

Lift two-dimensional intersection line obtained by tracing to three-dimensional space to obtain three-dimensional intersection line → S7

Calculate intersection points of boundary lines of $P_1$ and the three-dimensional intersection line, and split the three-dimensional intersection line into multiple segments at the intersection points → S8

Calculate a parameter value on $P_1$ corresponding to any point on the segments → S9

Determine whether the segments are to be trimmed based on whether the parameter value falls within a parameter domain, and obtain a final intersection line → S10

Trim the NURBS surfaces based on an intersection line to construct a CAD model → S11

FIG. 1

Calculate the moving planes corresponding to parameter surface $P_1$ → S41

Calculate Dixon matrix based on the moving planes → S42

Calculate the maximum linearly independent submatrix of the Dixon matrix → S43

Obtain the implicit equation of the parametric surface by calculating the determinant of the submatrix → S44

FIG. 2

FIG. 3

FIG. 4

FIG. 5

| Origin branches | is split? | splitting point | split branch | is abandoned? |
|---|---|---|---|---|
| branch 1 | ✕ | / | branch 1 | ✕ |
| branch 2 | ✕ | / | branch 2 | ✕ |
| branch 3 | ✕ | / | branch 3 | ✕ |
| branch 4 | ✕ | / | branch 4 | ✕ |
| branch 5 | ✓ | [-0.155,-1.751,2.822] | branch 5-1 | ✕ |
| | | | branch 5-2 | ✓ |
| branch 6 | ✓ | [-0.345,-2.716,2.580] | branch 6-1 | ✕ |
| | | | branch 6-2 | ✓ |
| branch 7 | ✕ | / | branch 7 | ✕ |
| branch 8 | ✕ | / | branch 8 | ✕ |
| branch 9 | ✓ | [0.132,-1.827,2.816] | branch 9-1 | ✓ |
| | | | branch 9-2 | ✕ |
| branch 10 | ✕ | / | branch 10 | ✓ |
| branch 11 | ✕ | / | branch 11 | ✕ |
| branch 12 | ✕ | / | branch 12 | ✕ |

FIG. 6

| Surfaces | AA-GPU | Mesh Booleans | OCCT | SISL | ACIS | Ours |
|---|---|---|---|---|---|---|
| example 1 (3,3) | 1.451 | 0.011 | NULL 0.003 | NULL N/A | 0.003 | a tangent line 0.036 |
| example 2 (3,3) | 1.775 | 0.038 | NULL 0.003 | NULL N/A | 0.005 | a tangential curve 0.082 |
| example 3 (3,3) | 1.836 | 0.008 | 0.076 | NULL 3.612 | 0.074 | a loop and two curves 0.054 |
| example 4 (3,3) | 0.388 | 0.013 | NULL 0.002 | NULL N/A | NULL 0.003 | a tangential curve 0.019 |
| example 5 (3,3) | 0.532 | 0.021 | 0.040 | NULL N/A | 0.054 | two loops 0.103 |
| example 6 (2,2) | 0.254 | 0.012 | 0.023 | NULL 0.288 | 0.008 | a loop and a point 0.514 |

FIG. 7

| Paras 5 | Surfaces | Intersection | Time cost | |
|---------|----------|--------------|-----------|------|
| | | | ACIS | Ours |
| example 1 | | | **0.031** | 0.039 |
| example 2 | | | **0.026** | 0.058 |
| example 3 | | | 0.168 | **0.039** |
| example 4 | | | 0.078 | **0.042** |
| example 5 | | | 0.154 | **0.053** |

FIG. 8

FIG. 9

## INTERNATIONAL SEARCH REPORT

| | International application No. |
|---|---|
| | **PCT/CN2024/106921** |

**A.     CLASSIFICATION OF SUBJECT MATTER**

G06F 30/10(2020.01)i

According to International Patent Classification (IPC) or to both national classification and IPC

**B.     FIELDS SEARCHED**

Minimum documentation searched (classification system followed by classification symbols)

IPC: G06F

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, IEEE, ISI, CNKI: NURBS, 曲面, 建模, 模型, 构建, 碰撞, 检测, 交点, 相交, 二维, 三维, surface, model, construction, collision, detection, intersection, 2D, 3D

**C.     DOCUMENTS CONSIDERED TO BE RELEVANT**

| Category* | Citation of document, with indication, where appropriate, of the relevant passages | Relevant to claim No. |
|---|---|---|
| PX | CN 116910834 A (ACADEMY OF MATHEMATICS AND SYSTEMS SCIENCE, CHINESE ACADEMY OF SCIENCES) 20 October 2023 (2023-10-20) claims 1-9, and description, paragraphs 42-117 | 1-10 |
| A | CN 115453753 A (CHANGCHUN INSTITUTE OF OPTICS, FINE MECHANICS AND PHYSICS, CHINESE ACADEMY OF SCIENCES) 09 December 2022 (2022-12-09) description, paragraphs [0005]-[0036] | 1-10 |
| A | CN 116310048 A (SHANGHAI MUCAN INFORMATION TECHNOLOGY CO., LTD.) 23 June 2023 (2023-06-23) entire document | 1-10 |
| A | CN 111914450 A (HUAZHONG UNIVERSITY OF SCIENCE AND TECHNOLOGY) 10 November 2020 (2020-11-10) entire document | 1-10 |
| A | CN 114880854 A (ACADEMY OF MATHEMATICS AND SYSTEMS SCIENCE, CHINESE ACADEMY OF SCIENCES) 09 August 2022 (2022-08-09) entire document | 1-10 |

☑ Further documents are listed in the continuation of Box C.          ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **09 September 2024** | **20 September 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2024/106921** |

**C.    DOCUMENTS CONSIDERED TO BE RELEVANT**

| Category* | Citation of document, with indication, where appropriate, of the relevant passages | Relevant to claim No. |
| --- | --- | --- |
| A | US 2020043231 A1 (BEIJING INSTITUTE OF TECHNOLOGY) 06 February 2020 (2020-02-06)<br>    entire document | 1-10 |

**INTERNATIONAL SEARCH REPORT**
Information on patent family members

International application No.

**PCT/CN2024/106921**

| Patent document cited in search report | | | Publication date (day/month/year) | Patent family member(s) | | | Publication date (day/month/year) |
|---|---|---|---|---|---|---|---|
| CN | 116910834 | A | 20 October 2023 | None | | | |
| CN | 115453753 | A | 09 December 2022 | None | | | |
| CN | 116310048 | A | 23 June 2023 | None | | | |
| CN | 111914450 | A | 10 November 2020 | None | | | |
| CN | 114880854 | A | 09 August 2022 | None | | | |
| US | 2020043231 | A1 | 06 February 2020 | WO | 2018059155 | A1 | 05 April 2018 |
| | | | | CN | 107067472 | A | 18 August 2017 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2023109118506